# DEMANDE DE BREVET EUROPEEN

(11) **EP 3 151 059 A1**
(43) Date de publication de la demande: **05.04.2017**
(21) Numéro de dépôt: 16188832.6
(22) Date de dépôt: 14.09.2016
(51) Int. Cl.: G02F 1/1335, G02B 5/00, B82Y 20/00, G02B 5/20, H01L 27/146

(54) **PROCÉDÉ DE FABRICATION D'UN FILTRE SPECTRAL NANOSTRUCTURÉ**

(30) Priorité: 30.09.2015 FR 1559267
(71) Demandeur: STmicroelectronics SA, 92120 Montrouge (FR); STMicroelectronics (Crolles 2) SAS, 38920 Crolles (FR); COMMISSARIAT À L'ÉNERGIE ATOMIQUE ET AUX ÉNERGIES ALTERNATIVES, 75015 Paris (FR)
(72) Inventeur: GIRARD DESPROLET, Romain, 74200 THONON LES BAINS (FR); MARTY, Michel, 38760 SAINT PAUL DE VARCES (FR); BOUTAMI, Salim, 38100 GRENOBLE (FR); LHOSTIS, Sandrine, 38570 THEYS (FR)
(74) Mandataire: Thibon, Laurent

(57) **Abrégé**

L'invention concerne un procédé de fabrication d'un filtre spectral comprenant les étapes successives suivantes :
a) former, dans une première couche en un premier matériau, un premier barreau rectangulaire (27) en un deuxième matériau d'indice optique différent de celui du premier matériau ; et
b) former, dans une deuxième couche ou dans la deuxième couche et à la fois dans une partie au moins de la première couche, un deuxième barreau rectangulaire (33) en le deuxième matériau et en contact avec le premier barreau, la deuxième couche reposant sur la première couche et étant en le premier matériau.

## Description

### Domaine

La présente demande concerne un procédé de fabrication d'un filtre spectral.

### Exposé de l'art antérieur

Les capteurs ou afficheurs d'images intégrés dans des dispositifs microélectroniques comprennent couramment une matrice de photodétecteurs ou de photoémetteurs réalisés dans un substrat semiconducteur. Chacun de ces photodétecteurs ou photoémetteurs est généralement surmonté d'un filtre spectral destiné à ne transmettre la lumière que pour une plage de longueurs d'ondes.

Un type connu de filtre spectral comprend une couche en un premier matériau dans laquelle est formé au moins un motif en un deuxième matériau d'indice optique différent de celui du premier matériau. Le motif s'étend à travers toute l'épaisseur de la couche du premier matériau et peut être répété périodiquement dans celle-ci. Dans le cas d'un filtre spectral plasmonique, l'un des premier et deuxième matériaux est un métal et l'autre est un diélectrique.

La figure 1 est une reproduction partielle de la figure 2 de la demande de brevet américaine N°2014/374574 de la demanderesse. Cette figure représente, en vue de dessus et de manière schématique, un réseau 1 de filtres spectraux 3, 5 et 7 disposé au-dessus d'une matrice de photodétecteurs, chaque filtre 3, 5 et 7 étant disposé au-dessus d'un photodétecteur de la matrice. Chaque filtre est constitué à partir d'une couche du premier matériau dans laquelle sont formés des motifs cruciformes en le deuxième matériau. Les dimensions des motifs sont choisies en fonction de la plage de longueurs d'ondes transmises de sorte que le filtre a un taux de transmission de la lumière aussi élevé que possible dans cette plage et un taux de rejection de la lumière aussi élevé que possible en dehors de cette plage. En fonction de la plage de longueurs d'ondes transmises, certaines dimensions des motifs peuvent être inférieures à une centaine de nanomètres.

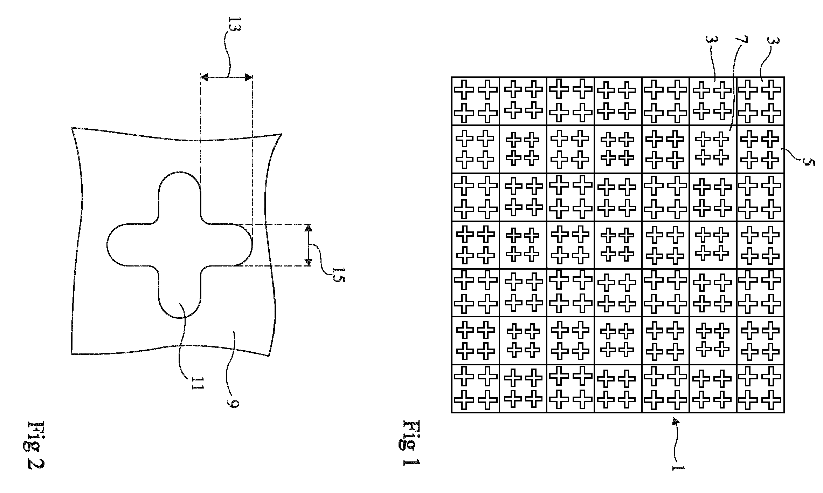

En pratique, pour fabriquer un filtre du type de ceux de la figure 1, la couche du premier matériau est déposée puis, pour chaque motif, un trou ayant la forme du motif est gravé à travers la couche. Le deuxième matériau est alors déposé de manière à remplir chaque trou et y former le motif correspondant.

Dans le cas de motifs tels que des croix ou des étoiles, dont certaines dimensions sont par exemple inférieures à une centaine de nanomètres, un tel procédé de fabrication présente divers inconvénients à au moins certains desquels la présente demande vise à remédier.

### Résumé

Ainsi, un mode de réalisation prévoit un procédé de fabrication d'un filtre spectral comprenant les étapes successives suivantes : a) former, dans une première couche en un premier matériau, un premier barreau rectangulaire en un deuxième matériau d'indice optique différent de celui du premier matériau ; et b) former, dans une deuxième couche ou dans la deuxième couche et à la fois dans une partie au moins de la première couche, un deuxième barreau rectangulaire en le deuxième matériau et en contact avec le premier barreau, la deuxième couche reposant sur la première couche et étant en le premier matériau.

Selon un mode de réalisation, le premier matériau et le deuxième matériau sont respectivement un métal et un diélectrique, ou inversement.

Selon un mode de réalisation, l'étape a) comprend les étapes successives suivantes : a1) graver à travers toute l'épaisseur de la première couche une première cavité rectangulaire ; et a2) remplir la première cavité du deuxième matériau pour y former le premier barreau.

Selon un mode de réalisation, l'étape b) comprend les étapes successives suivantes : b1) déposer la deuxième couche sur la première couche ; b2) graver, à travers toute l'épaisseur de la deuxième couche et éventuellement à travers au moins une partie de l'épaisseur de la première couche, une deuxième cavité rectangulaire ; et b3) remplir la deuxième cavité du deuxième matériau pour y former le deuxième barreau.

Selon un mode de réalisation, l'étape a2) comprend les étapes successives suivantes : déposer une couche du deuxième matériau sur la première couche de manière à remplir la première cavité ; et retirer une partie du deuxième matériau par gravure aplanissante jusqu'à la face supérieure de la première couche.

Selon un mode de réalisation, le premier barreau et le deuxième barreau s'étendent en longueur dans des directions différentes.

Selon un mode de réalisation, lesdites directions sont orthogonales.

Un autre mode de réalisation prévoit un filtre spectral comprenant une couche en un premier matériau dans laquelle sont disposés un premier barreau et un deuxième barreau en un deuxième matériau d'indice optique différent de celui du premier matériau, le deuxième barreau s'étendant en longueur dans une direction différente de celle du premier barreau et ayant une portion reposant sur le premier barreau.

Un autre mode de réalisation prévoit un capteur d'image comprenant : une matrice de photodétecteurs disposés dans et/ou sur un substrat semiconducteur ; et le filtre spectral susmentionné surmontant au moins un photodétecteur de la matrice.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est une reproduction partielle de la figure 2 de la demande de brevet américaine N°2014/374574 ;
la figure 2 est une vue de dessus schématique d'un motif de filtre spectral ;
les figures 3A à 3E sont des vues en coupe et en perspective illustrant des étapes successives d'un mode de réalisation d'un procédé de fabrication d'un filtre spectral ;
les figures 4C et 4E sont des vues en coupe et en perspective illustrant une variante des étapes des figures 3C et 3E ;
les figures 5C et 5E sont des vues en coupe et en perspective illustrant une autre variante des étapes des figures 3C et 3E ; et
les figures 6A et 6B illustrent l'évolution du taux de transmission de la lumière en fonction de la longueur d'onde et pour différents angles d'incidence de la lumière, pour divers types de filtre.

### Description détaillée

De mêmes éléments ont été désignés par de mêmes références aux différentes figures et, de plus, les diverses figures ne sont pas tracées à l'échelle. Dans la description qui suit, les termes "dessus", "dessous", "supérieur" et "inférieur" font référence à l'orientation des éléments concernés dans les figures correspondantes. Sauf précision contraire, le terme "environ" signifie à 10 % près, de préférence à 5 % près.

La figure 2 est une vue de dessus schématique d'un motif d'un filtre spectral du type de ceux de la figure 1.

Un trou cruciforme a été gravé à travers une couche 9 en un premier matériau puis le trou a été rempli d'un deuxième matériau pour y former un motif cruciforme 11 du filtre.

En raison de limitations technologiques liées à l'étape de gravure, les angles du motif 11 du filtre ne sont pas nets mais arrondis. On constate que les propriétés optiques d'un tel filtre (taux de réjection en dehors de la plage de longueurs d'ondes transmises, sélectivité, insensibilité à l'angle d'incidence de la lumière, etc.) sont alors moins bonnes que prévues. Cela est plus particulièrement vrai lorsque le motif 11 a des dimensions inférieures à une centaine de nanomètres, par exemple, lorsque des bras du motif ont un premier côté d'une longueur 13 inférieure à 100 nm et un deuxième côté d'une longueur 15 inférieure à 100 nm. Cette dégradation des propriétés optiques est attribuée au caractère arrondi des angles du motif.

On propose ici de fabriquer un filtre équivalent à ceux des figures 1 et 2, en réalisant chaque motif du filtre à partir de barreaux en le deuxième matériau formés les uns après les autres dans une couche du premier matériau.

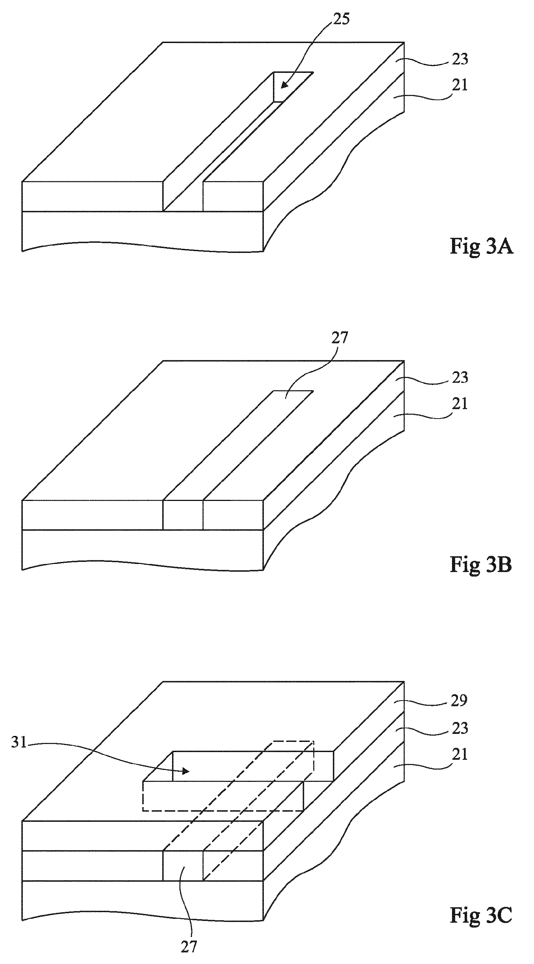

Les figures 3A à 3D sont des vues en coupe et en perspective illustrant des étapes successives d'un procédé de fabrication d'un filtre spectral.

La figure 3A représente une structure comprenant un support 21 après le dépôt d'une couche 23 d'un premier matériau sur la face supérieure du support 21, et la gravure d'une cavité rectangulaire 25 à travers toute l'épaisseur de la couche 23. La cavité 25 s'étend longitudinalement dans une première direction.

La figure 3B représente la structure de la figure 3A après le remplissage de la cavité 25 par un deuxième matériau pour y former un barreau 27. A titre d'exemple, le remplissage de la cavité est réalisé en déposant une couche du deuxième matériau sur la face supérieure de la couche 23 et dans la cavité 25, puis en retirant l'excédent du deuxième matériau par gravure aplanissante, ou CMP ("Chemical Mechanical Polishing"-polissage mécanico-chimique), jusqu'à la face supérieure de la couche 23. La face supérieure du barreau 27 est alors au niveau de la face supérieure de la couche 23.

La figure 3C représente la structure de la figure 3B après le dépôt d'une couche 29 du premier matériau sur la face supérieure de la couche 23 et la gravure d'une cavité rectangulaire 31 à travers toute l'épaisseur de la couche 29. La gravure de la cavité 31 est effectuée de sorte qu'une partie de cette cavité soit en regard d'une portion du barreau 27. La cavité 31 s'étend longitudinalement dans une deuxième direction différente de la première direction dans laquelle s'étend le barreau 27. Par exemple, les première et deuxième directions sont orthogonales.

Dans ce mode de réalisation, comme cela est représenté en figure 3C, la gravure de la cavité 31 est arrêtée sur le barreau 27, c'est-à-dire au niveau de la face supérieure de celui-ci.

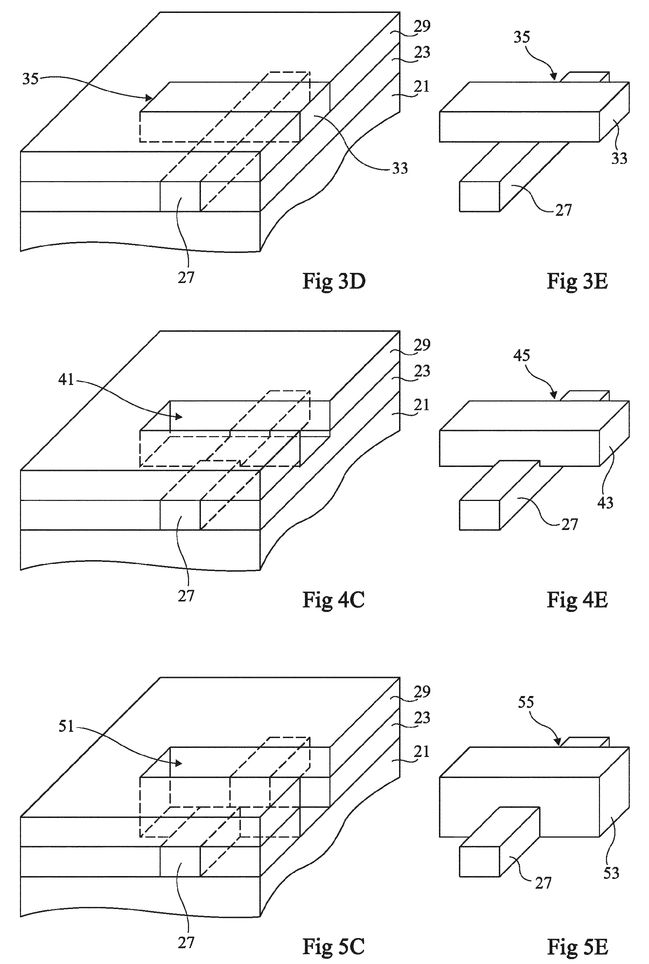

Les figures 3D et 3E représentent la structure de la figure 3C après le remplissage de la cavité 31 par le deuxième matériau pour y former un barreau 33 qui repose sur le barreau 27, le support 21 et les couches 23 et 29 n'étant pas représentées en figure 3E. Les deux barreaux 27 et 33 forment, en vue de dessus non représentée, un motif 35 cruciforme équivalent au motif 11 de la figure 2. Le motif 35 n'a pas, au moins en partie, les inconvénients du motif 11.

A titre d'exemple, de manière similaire à l'étape décrite en relation avec la figure 3B, le remplissage de la cavité 31 est réalisé en déposant une couche du deuxième matériau sur la face supérieure de la couche 29 et dans la cavité 31, puis en retirant l'excédent du deuxième matériau par gravure aplanissante. La gravure aplanissante peut être arrêtée sur la face supérieure de la couche 29, comme cela est représenté ici, ou au-dessus de la face supérieure de la couche 29 de sorte qu'il reste une couche du deuxième matériau revêtant la face supérieure de la couche 29.

Les figures 4C et 4E, analogues aux figures 3C et 3E, illustrent une variante de réalisation des étapes décrites en relation avec les figures 3C et 3E.

La figure 4C représente la structure de la figure 3B après le dépôt de la couche 29 et la gravure d'une cavité rectangulaire 41 dans cette couche 29. La cavité 41 est similaire à la cavité 31 à la différence que la gravure de la cavité 41 est arrêtée dans le barreau 27 et la couche 23. Le fond de la cavité 41 est alors à un niveau inférieur à celui de la face supérieure du barreau 27.

La figure 4E représente la structure de la figure 4C après le remplissage de la cavité 41 par le deuxième matériau pour y former un barreau 43. De manière similaire aux barreaux 27 et 33, les barreaux 27 et 43 forment un motif 45 cruciforme équivalent au motif 11 de la figure 2 à la différence que le barreau 43 pénètre sur une partie de l'épaisseur du barreau 27. Le motif 45 n'a pas, au moins en partie, les inconvénients du motif 11.

Les figures 5C et 5E, analogues aux figures 3C et 3E, illustrent une autre variante de réalisation des étapes décrites en relation avec les figures 3C et 3E.

La figure 5C représente la structure de la figure 3B après le dépôt de la couche 29 et la gravure d'une cavité 51 dans cette couche 29. La gravure de la cavité 51 est similaire à celle de la cavité 31 à la différence que la cavité 51 est gravée à travers toute l'épaisseur du barreau 27 et de la couche 23. Le fond de la cavité 51 est alors au même niveau que celui de la face inférieure de la couche 23.

La figure 5E représente la structure de la figure 5C après le remplissage de la cavité 51 par le deuxième matériau pour y former un barreau 53. De manière similaire aux barreaux 27 et 33, les barreaux 27 et 53 forment un motif 55 cruciforme équivalent au motif 11 de la figure 2 à la différence que le barreau 53 pénètre sur toute l'épaisseur du barreau 27. Le motif 55 n'a pas, au moins en partie, les inconvénients du motif 11.

Du fait que, dans les procédés de fabrication décrits en relation avec les figures 3A à 5E, les barreaux constitutifs d'un motif d'un filtre spectral sont formés les uns après les autres, les angles du motif sont nets contrairement au cas où le motif est obtenu selon le procédé décrit en relation avec la figure 2. Au moins certaines propriétés optiques d'un filtre comprenant un motif du type de ceux des motifs 35, 45 ou 55 sont alors meilleures que celles d'un filtre comprenant des motifs du type de celui du motif 11.

Comme cela a été indiqué précédemment, les premier et deuxième matériaux et les différentes dimensions des motifs 35, 45 ou 55 sont choisis en fonction de la plage de longueurs d'ondes que le filtre doit transmettre. Ces matériaux et ces dimensions peuvent être déterminés au moyen d'un outil de simulation tel que Comsol, Lumerica, ou Rsoft.

Du fait que, contrairement à un motif 11, chaque barreau d'un motif 35, 45 ou 55 peut avoir une épaisseur différente et peut pénétrer plus ou moins profondément dans un autre barreau du motif, l'homme de métier dispose de paramètres supplémentaires pour adapter les propriétés optiques d'un filtre comprenant un ou plusieurs de ces motifs 35, 45 ou 55.

En outre, le fait de réaliser les barreaux d'un motif les uns après les autres permet de fabriquer un motif dans lequel l'angle entre les directions longitudinales de deux barreaux du motif est inférieur à 45°, par exemple de 20°, ce qui n'est pas réalisable avec le procédé de fabrication décrit en relation avec la figure 2 lorsque les dimensions des barreaux deviennent inférieures à une centaine de nanomètres.

A titre d'exemple, le premier matériau est un métal choisi dans le groupe comprenant l'aluminium, le cuivre, le tungstène, le platine, l'argent, l'or ou un alliage d'au moins deux de ces métaux. Le deuxième matériau est par exemple un matériau diélectrique choisi dans le groupe comprenant le nitrure de silicium, l'oxynitrure de silicium, l'oxyde de silicium, le dioxyde de titane, le fluorure de magnésium, l'oxyde d'hafnium ou le carbure de silicium. Les premier et deuxième matériaux peuvent être inversés. Les premier et deuxième matériaux peuvent également être des matériaux diélectriques d'indices optiques différents.

Le support 21 est par exemple une couche du deuxième matériau. Dans ce cas, aux étapes des figures 3E, 4E et 5E, lorsqu'une couche du deuxième matériau est laissée en place sur la face supérieure du premier matériau, le motif 35, 45 ou 55 s'étend alors entre deux couches du deuxième matériau. Le support 21 peut également être la couche supérieure d'un empilement de couches revêtant un substrat semiconducteur dans lequel sont formés un ou plusieurs photodétecteurs ou photoémetteurs. Le support 21 peut également être une vitre d'une fenêtre, par exemple pour bloquer les rayons ultraviolets et/ou infrarouges.

A titre d'exemple comparatif, on considère un premier filtre et un deuxième filtre dont la bande passante est centrée sur la longueur d'onde 420 nm, c'est-à-dire des filtres laissant passer la lumière visible violette. Le premier filtre comprend un premier motif cruciforme sur un seul niveau et le deuxième filtre comprend un deuxième motif cruciforme du type de celui de la figure 3E, sur deux niveaux et équivalent au premier motif. Chaque bras du premier motif a une épaisseur de 40 nm, un premier côté dont la longueur 13 est de 24 nm, et un deuxième côté dont la longueur 15 est de 72 nm. Chaque barreau 27 et 33 du deuxième motif a une épaisseur de 20 nm, une longueur de 120 nm et une largeur de 72 nm. Chaque motif est en oxyde de silicium et est répété périodiquement dans une couche d'aluminium selon une période de 150 nm.

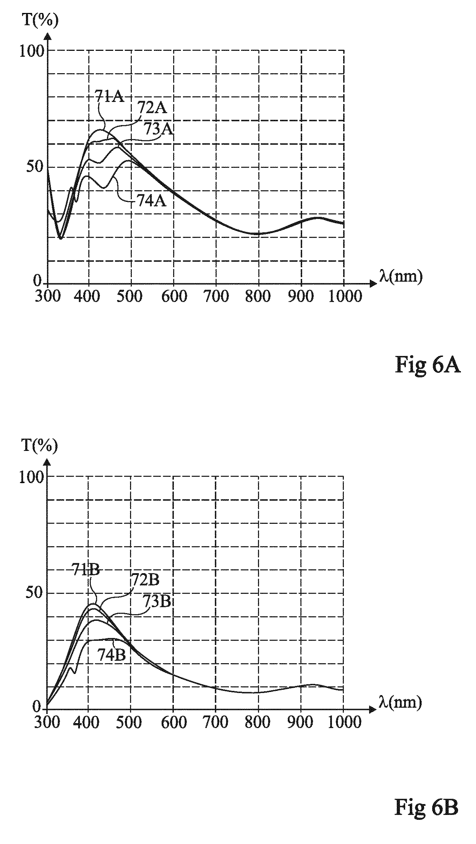

Les figures 6A et 6B illustrent, respectivement pour le premier filtre et le deuxième filtre définis dans l'exemple comparatif, l'évolution du taux de transmission T (en %) en fonction de la longueur d'onde λ (en nm). Ces courbes sont obtenues par simulation dans le cas idéal où les motifs des filtres sont parfaits, c'est-à-dire que leurs angles ne sont pas arrondis.

La figure 6A comprend quatre courbes 71A, 72A, 73A et 74A de l'évolution du taux de transmission T en fonction de la longueur d'onde λ, respectivement pour des angles d'incidence de la lumière de 0, 15, 30 et 60°.

La figure 6B comprend quatre courbes 71B, 72B, 73B et 74B de l'évolution du taux de transmission T en fonction de la longueur d'onde λ, respectivement pour des angles d'incidence de la lumière de 0, 15, 30 et 60°.

Comme cela se voit sur ces figures, pour une longueur d'onde d'environ 420 nm, les écarts entre les courbes 71B, 72B, 73B et 74B prises deux à deux sont plus faibles que les écarts correspondants entre les courbes 71A, 72A, 73A et 74A. Autrement dit, le deuxième filtre comprenant le motif 35 sur deux niveaux est moins sensible à l'angle d'incidence de la lumière que le premier filtre comprenant le motif 11 sur un seul niveau.

Pour des longueurs d'ondes éloignées de la bande passante, les valeurs des taux de transmission des courbes 71B, 72B, 73B et 74B sont inférieures aux valeurs des taux de transmission correspondantes des courbes 71A, 72A, 73A et 74A respectivement. Autrement dit, le taux de réjection du deuxième filtre, en dehors de la bande passante, est meilleur que celui du premier filtre.

On constate également que la bande passante du deuxième filtre est plus étroite que celle du premier filtre. Autrement dit, le deuxième filtre est plus sélectif que le premier.

Ainsi, le deuxième filtre a des propriétés optiques dont certaines sont meilleures que celles du premier filtre.

Les avantages du deuxième filtre par rapport au premier filtre apparaissent encore plus nettement dans le cas où le premier filtre est un filtre réel ayant des motifs cruciformes arrondis tels que représentés en figure 2, et le deuxième filtre est un filtre réel obtenu selon le procédé des figures 3A à 3E. Les inventeurs ont constaté que, pour des filtres ayant les dimensions définies ci-dessus, la valeur maximale du taux de transmission du premier filtre devient inférieure à 40 %, au lieu de 65 % dans le cas idéal, alors que la valeur maximale du taux de transmission du deuxième filtre reste égale à 45 %.

Les avantages du deuxième filtre par rapport au premier filtre restent vrais lorsque le motif du premier filtre est obtenu selon le procédé décrit en relation avec les figures 4C et 4E ou avec les figures 5C et 5E.

On a décrit précédemment des procédés de fabrication d'un filtre comprenant un motif pouvant être décomposé en deux barreaux. On comprend que ces procédés de fabrication peuvent être adaptés pour fabriquer des filtres dont le ou les motifs peuvent être décomposés en plus de deux barreaux. Par exemple, un motif décomposable en trois barreaux peut être obtenu à partir d'une structure du type de celles obtenues aux étapes illustrées par les figures 3E, 4E et 5E en déposant une couche supplémentaire du premier matériau sur la couche 29 ; en gravant ensuite une autre cavité rectangulaire à travers cette couche jusqu'à l'un et/ou l'autre des barreaux 27 et 33, 43, ou 53 ; et en remplissant cette autre cavité du deuxième matériau pour y former un troisième barreau du motif.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Procédé de fabrication d'un filtre spectral comprenant les étapes successives suivantes :
a) former, dans une première couche (23) en un premier matériau, un premier barreau rectangulaire (27) en un deuxième matériau d'indice optique différent de celui du premier matériau ; et
b) former, dans une deuxième couche (29) ou dans la deuxième couche et à la fois dans une partie au moins de la première couche, un deuxième barreau rectangulaire (33 ; 43 ; 53) en le deuxième matériau et en contact avec le premier barreau, la deuxième couche reposant sur la première couche et étant en le premier matériau, le premier matériau et le deuxième matériau étant respectivement un métal et un diélectrique, ou inversement, le premier barreau et le deuxième barreau s'étendant en longueur dans des directions différentes.

2. Procédé de fabrication selon la revendication 1, dans lequel l'étape a) comprend les étapes successives suivantes :
a1) graver à travers toute l'épaisseur de la première couche une première cavité rectangulaire (25) ; et
a2) remplir la première cavité du deuxième matériau pour y former le premier barreau (27).

3. Procédé selon la revendication 2, dans lequel l'étape b) comprend les étapes successives suivantes :
b1) déposer la deuxième couche (29) sur la première couche (23) ;
b2) graver, à travers toute l'épaisseur de la deuxième couche et éventuellement à travers au moins une partie de l'épaisseur de la première couche, une deuxième cavité rectangulaire (31 ; 41 ; 51) ; et
b3) remplir la deuxième cavité du deuxième matériau pour y former le deuxième barreau (33 ; 43 ; 53).

4. Procédé de fabrication selon la revendication 2 ou 3, dans lequel l'étape a2) comprend les étapes successives suivantes :
déposer une couche du deuxième matériau sur la première couche (23) de manière à remplir la première cavité (25) ; et
retirer une partie du deuxième matériau par gravure aplanissante jusqu'à la face supérieure de la première couche.

5. Procédé selon la revendication 4, dans lequel lesdites directions sont orthogonales.

6. Filtre spectral comprenant une couche (23, 29) en un premier matériau dans laquelle sont disposés un premier barreau (27) et un deuxième barreau (35) en un deuxième matériau d'indice optique différent de celui du premier matériau, le deuxième barreau s'étendant en longueur dans une direction différente de celle du premier barreau et ayant une portion reposant sur le premier barreau, le premier matériau et le deuxième matériau étant respectivement un métal et un diélectrique, ou inversement.

7. Capteur d'image comprenant :
une matrice de photodétecteurs disposés dans et/ou sur un substrat semiconducteur ; et
le filtre spectral selon la revendication 6 surmontant au moins un photodétecteur de la matrice.
